# FASCICULE DE BREVET EUROPEEN

(11) **EP 0 498 700 B1**
(45) Date de publication et mention de la délivrance du brevet: **18.09.1996**
(21) Numéro de dépôt: 92400248.8
(22) Date de dépôt: 30.01.1992
(51) Int. Cl.: G02B 6/42

(54) **Procédé de fabrication d'un dispositif optoélectronique**
Verfahren zur Herstellung eines opto-elektronischen Bauteils
Method of manufacturing an opto-electronic device

(30) Priorité: 08.02.1991 FR 9101469
(43) Date de publication de la demande: 12.08.1992
(73) Titulaire: ALCATEL N.V., NL-1077 XX Amsterdam (NL)
(72) Inventeur: Maignan, Michel, F-91460 Marcoussis (FR); Ducate, Jean, F-94240 l'Hay les Roses (FR)
(74) Mandataire: Bourely, Paul

(56) Documents cités:
- EP-A- 0 017 701
- WO-A-87/01465
- FR-A- 2 440 563
- US-A- 4 690 492

## Description

La présente invention concerne la fabrication d'un dispositif optoélectronique qui est monté sur un substrat et dont une connexion optique est réalisée par une fibre optique. Elle trouve notamment application dans la réalisation d'un récepteur optique destiné à un système de transmission à fibres optiques . Dans un tel système une onde lumineuse porte un signal numérique qui peut être porté soit en modulation d'intensité avec détection directe, soit en modulation de fréquence ou de phase avec détection cohérente. Dans le cas où ce signal est à haut débit la détection est réalisée à l'aide de composants fonctionnant dans le domaine des hyperfréquences, par exemple 1,8 GHz, et ces composants sont avantageusement intégrés dans un circuit hybride formé sur un substrat céramique.

Dans un tel récepteur un signal lumineux d'entrée est guidé par une fibre optique et reçu par une photodiode suivie par un premier amplificateur du récepteur. La connexion électrique de ces deux composants pose un problème technique délicat lorsque la fréquence du signal électrique est élevée : La capacité parasite de la ligne de connexion limite en effet la bande passante du récepteur et introduit un bruit supplémentaire. De plus, dès que l'on éloigne la photodiode, la désadaptation d'impédance entre la photodiode et l'amplificateur fait apparaître dans cette ligne des ondes stationnaires qui perturbent le fonctionnement du circuit. Différentes dispositions ont été proposées pour résoudre ce problème ; elles comportent toutes la suppression du boîtier dans lequel la photodiode est classiquement contenue et la réalisation d'une connexion électrique directe de celle-ci à l'amplificateur pour éliminer la capacité parasite de ce boîtier. Le maintien de la fibre optique dans une position assurant une bonne connexion optique pose alors un autre problème qui devient complexe si le dispositif doit être prévu pour résister à des contraintes mécaniques. Une solution à ce problème de connexion optique est décrite dans le document (WO-A-87/01465 - BRITISH TELECOMMUNICATIONS) : La fibre optique 4 est maintenue directement par les bords d'un trou de connexion optique formé pour cela dans un substrat céramique 1 à l'aide d'un laser. Cependant, selon ce document, un trou percé au laser dans une plaquette céramique présente une forme conique qui ne permet pas de réaliser un maintien et un alignement correct de la fibre optique. C'est pourquoi le substrat est réalisé par superposition de plusieurs plaquettes céramiques à travers chacune desquelles un trou conique de mêmes dimensions a été percé. Ces trous sont alignés de manière à assurer le maintien et l'alignement de la fibre et les cônes sont orientés dans le sens qui facilite l'introduction de cette dernière. Ce mode de fabrication est complexe et coûteux.

Une autre solution au même problème est décrite dans le document FR-A-2440 563 qui divulgue un dispositif optoélectronique monté sur substrat et connecté par fibre optique. Un composant optoélectronique est fixé sur un substrat constitué d'une plaquette souple en polyimide. La connexion électrique de ce composant est assurée par contact de ce composant avec au moins une piste conductrice. Sa connexion optique est assurée par une fibre optique maintenue dans un trou de connexion optique traversant ce substrat. Ce trou est susceptible de présenter une paroi sensiblement continue cylindrique de révolution dont le diamètre est adapté à celui de la fibre optique pour que cette paroi assure l'alignement et le maintien de celle-ci.

Cette dernière solution n'apparaît pas économiquement transposable au cas où le substrat doit être constitué d'une céramique.

La présente invention vise à permettre de fabriquer simplement un dispositif de ce genre tout en bénéficiant des avantages des substrats céramiques.

Quoique on ait considéré ci-dessus les problèmes liés à la réalisation d'un récepteur optique à l'aide d'une photodiode il doit être compris que la présente invention s'applique aussi à la réalisation de dispositifs autres qu'un tel récepteur optique et à la connexion de composants optoélectroniques autres qu'une telle photodiode, par exemple un photo-transistor, un composant hyperfréquence commandé optiquement, ou un laser semi-conducteur lorsque ces composants sont disposés sur des substrats céramiques.

Elle a dans ces divers cas le but général suivant : réalisation simple d'une connexion optique durablement précise sur un substrat céramique tel que celui d'un circuit hybride.

Dans ce but elle a pour objet un procédé selon la revendication 1 annexée.

A l'aide des figures schématiques ci-jointes, on va décrire ci-après comment la présente invention peut être mise en oeuvre, étant entendu que les éléments et dispositions mentionnés et représentés ne le sont qu'à titre non limitatif. Lorsqu'un même élément est représenté sur plusieurs figures il y est désigné par le même signe de référence.

La figure 1 représente une vue de dessus d'un circuit hybride simplifié constituant un premier dispositif obtenu par le procédé de fabrication selon la présente invention.

La figure 2 représente une vue en coupe de ce circuit.

La figure 3 représente une vue de dessous de ce circuit.

Les figures 4A, 4B, 4C, 4D, 4E, 4F, 4G, représentent des vues encoupe à échelle réduite de ce circuit à des étapes successives de sa fabrication.

La figure 5 représente une vue en coupe à échelle agrandie d'une photodiode constituant un composant optoélectronique de ce circuit.

La figure 6 représente une vue de dessus d'un circuit hybride plus complexe constituant un deuxième dispositif obtenu par le procédé selon la présente invention.

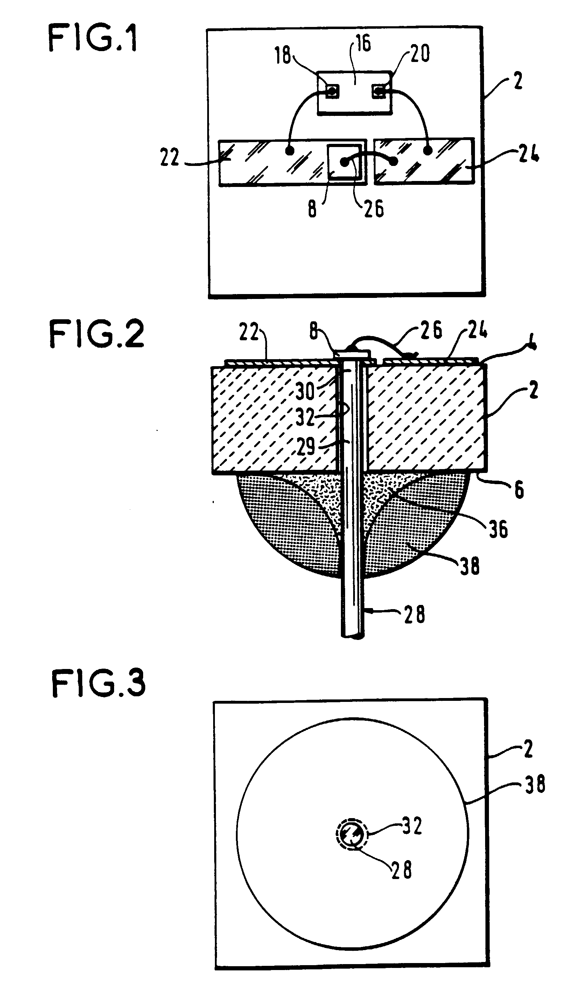

En se référant aux figures 1 à 3 on va d'abord décrire de manière générale certaines dispositions qui, quant à leurs finalités indiquées ci-après, sont communes à un dispositif fabriqué selon le procédé selon la présente invention et à des dispositifs bien connus. On donnera en même temps quelques indications un peu plus particulières à titre d'exemple.

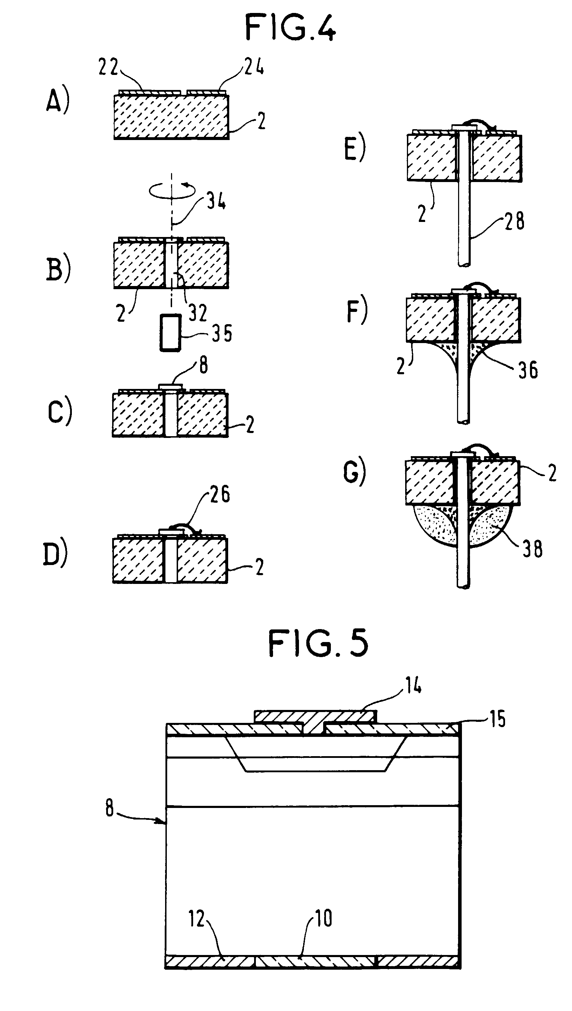

Selon ces dispositions communes un dispositif optoélectronique est réalisé sous la forme d'un circuit hybride et comporte les éléments suivants :
- Un substrat 2. Il présente deux faces principales qui sont une face supérieure 4 et une face inférieure 6. Il est constitué d'une plaquette de matériau céramique.
- Un ensemble de composants électroniques. Ces composants sont pourvus de bornes de connexion électriques. Cet ensemble comporte au moins un composant optoélectronique 8. Ce dernier est pourvu de deux bornes de connexion électriques inférieure 12 et supérieure 14 (fig.5). Il est en outre pourvu d'une plage de connexion optique 10. Un autre composant électronique 16 possède deux bornes de connexion électriques 18 et 20. Tous ces composants sont fixés sur la face supérieure 4 du substrat 2.
- Des lignes de connexion reliées à ces bornes pour établir des connexions électriques utiles au fonctionnement du dispositif. De telles lignes peuvent également permettre de connecter le dispositif à des organes extérieurs. Elles sont constituées par des pistes telles que 22 et 24 fixées sur le substrat 2 et par des fils métalliques tels que 26 soudées à ces bornes sur ces pistes.
- Une fibre optique 28 dont un tronçon extrême présente une extrémité libre 30 en regard de la plage 10 du composant optoelectronique 8 de manière à établir une connexion optique utile pour le fonctionnement du dispositif.
- Enfin des moyens de maintien de fibre 32, 36 pour maintenir ce tronçon extrême par rapport au substrat 2. Ces moyens assurent la permanence du couplage optique entre la fibre optique et le composant optoélectronique, même en présence d'efforts mécaniques provenant de chocs ou de vibrations. Pour les constituer, le substrat 2 est percé d'un trou de connexion optique 32 reliant ses deux faces principales 4 et 6. Le composant optoélectronique 8 est positionné sur la face supérieure 4 de ce substrat de manière à présenter sa plage de connexion optique 10 en regard de ce trou. La fibre optique 28 s'etend au dessous de ce substrat et comporte au voisinage de son extrémité libre 30 un tronçon extrême 29 engagé dans ce trou.

Selon le procédé selon la présente invention le trou de connexion optique 32 a une surface cylindrique avec un diamètre constant adapté à un diamètre extérieur du tronçon extrême de fibre optique 29 pour que la paroi de ce trou assure l'alignement et le maintien de ce tronçon. Ce diamètre est typiquement inférieur à 0,2 mm.

On va maintenant décrire, encore de manière générale, en se référant aux figures 4 et 5, le procédé de fabrication d'un tel dispositif. Ce procédé comporte diverses opérations qui, quant à leurs finalités indiquées ci-après, sont communes à ce procédé et à des procédés connus. Dans un ordre non chronologique, ces opérations communes sont les suivantes :
- positionnement d'un ensemble de composants électroniques 8, 16 sur une face supérieure 4 d'un substrat 2, cet ensemble comportant au moins un composant optoélectronique 8 présentant une plage de connexion optique 10,
- fixation de cet ensemble sur cette face,
- réalisation de connexions électriques 22, 24, 26 pour cet ensemble,
- positionnement d'un tronçon extrême 29 d'une fibre optique 28 par rapport au substrat 2 de manière à amener une première extrémité 30 de cette fibre en regard de la plage de connexion optique 10 du composant optoélectronique 8,
- et fixation de cette fibre à ce substrat pour réaliser une connexion optique de ce composant optoélectronique.

Conformément à la présente invention ce procédé comporte en outre une opération de perçage pour percer un trou de connexion optique 32 à travers le substrat 2. L'opération de positionnement du composant optoélectronique 8 améne alors la plage de connexion optique 10 de ce composant optoélectronique 8 en regard de ce trou, et l'opération de positionnement du tronçon extrême 29 de fibre optique comporte l'insertion de ce tronçon dans ce trou.

Le substrat 2 étant constitué d'une plaquette céramique, l'opération de perçage est réalisée à l'aide d'un faisceau laser focalisé. Elle forme le trou de connexion optique 32 selon un axe de perçage 34 qui est par exemple perpendiculaire à ce substrat. Elle donne à ce trou un diamètre adapté à un diamètre extérieur de la fibre optique 28. Pour donner à la paroi de ce trou la forme d'un cylindre de révolution, ou à peu près, on fait tourner le substrat 2 autour de l'axe de perçage 34 pendant cette opération.

On va maintenant décrire ce procédé d'une manière plus particulière dans le cas où le composant optoélectronique est une photodiode 8. On choisit une photodiode présentant sa plage de connexion optique 10 sur une face qui est généralement dite "arrière" et qui deviendra ici sa face inférieure. Cette plage est entourée (fig.5) par une borne de connexion electrique inférieure 12. L'autre borne de connexion electrique 14 est formée sur la face supérieure en regard d'une fenêtre percée dans une couche diélectrique 15. Les opérations relatives à l'autre composant électronique 16 sont classiques et ne seront ni décrites ni représentées.

Dans l'ordre chronologique les opérations concernant la photodiode sont les suivantes :
- Choix de l'emplacement de la photodiode 8 sur le substrat 2.
- Gravure d'une couche métallique déposée sur ce substrat pour former les pistes de connexion électrique 22, 24 jusqu'à l'emplacement choisi pour la photodiode (fig.4A).
- Perçage du trou 32 adapté au diamètre de la fibre optique. Ce perçage est fait à l'emplacement choisi pour la photodiode en extrémité de la piste 22. Ce trou est réalisé par micro-usinage à l'aide du faisceau d'un laser 35, selon l'axe 34, pendant que le substrat 2 est entraîné en rotation autour de cet axe (fig.4B).
- Positionnement de la photodiode 8 au dessus du trou 32. La face arrière est placée du côté du trou. La photodiode est mise en place par une machine de report de composants et fixée à l'aide d'une colle conductrice. Ceci réalise la fixation et une première connexion de cette photodiode par contact électrique entre sa borne inférieure 12 et la piste 22 (fig.4C).
- Une deuxième connexion de cette photodiode est réalisée sur sa face avant par un fil d'or 26 qui est soudé d'une part à sa borne supérieure 14 d'autre part à la piste 24 (fig.4D).
- On prépare la fibre optique 28, dite fibre amorce. Son extrémité 30 est taillée avec un angle pour minimiser les réflexions optiques.
- Insertion du tronçon extrême 29 de la fibre 28 dans le trou 32 à partir de l'extrémité inférieure de ce trou jusqu'à ce que son extrémité affleure la photodiode (fig.4E).
- Fixation de cette fibre à l'aide d'une goutte de colle dure 36 déposée sous le substrat 2 (fig.4F).
- On assure la souplesse de raccordement de la fibre 28 sur le substrat 2 en recouvrant la goutte de colle dure 36 par une goutte de polymère souple 38. Cette opération à pour but d'éviter que la fibre casse quand elle est courbée par l'utilisateur.

Plus particulièrement le substrat 2 est une plaquette d'alumine de 0,635 mm d'épaisseur. Les pistes de connexion électrique en or sont gravées dessus par les méthodes habituelles.

Le trou 32 qui traverse le substrat a un diamètre de 0,14 mm. Il est percé par micro-usinage au laser excimère. Pendant le perçage le substrat est mis en rotation pour obtenir un trou presque parfaitement cylindrique.

La photodiode 8 est placée par une machine de report de composants. Un dispositif à dépression permet de la maintenir pendant qu'un chariot mobile suivant les trois axes positionne le substrat. Une visée optique à travers le trou permet d'obtenir la précision de positionnement requise. La photodiode est fixée par une colle conductrice type H2OE de la marque déposée Epotecny. Cette colle a été préalablement déposée à l'aide d'une aiguille sur la piste 22 sur le bord du trou 32.

La deuxième connexion sur la face avant de la photodiode est réalisée par une machine de thermocompression à l'aide du fil d'or 26 dont le diamètre est 0,018mm.

La fibre 28 est une fibre monomode de diamètre 0,125mm. Son coeur a un diamètre de 8 micromètres. Son extrémité 30 a été inclinée à 6° d'angle par polissage. Elle est positionnée au dessus du trou puis descendue à l'aide d'une pince mobile suivant les trois axes. Il est possible pendant cette opération d'injecter de la lumière dans la fibre afin de contrôler la qualité du couplage optique.

La goutte de colle 36 est du type E de la marque déposée Epotecny. Elle est déposée à l'aide d'une aiguille sous le substrat au contact de la fibre optique.

La goutte de protection 38 assurant un raccordement souple de la fibre avec le substrat est déposé à l'aide d'une aiguille. Un exemple de produit pouvant assurer cette fonction est le joint 3020 de la marque déposée TECSIL.

On peut ainsi obtenir une sensibilité supérieure à 0,85 A/W ainsi qu'une bande passante supérieure à 2 GHz.

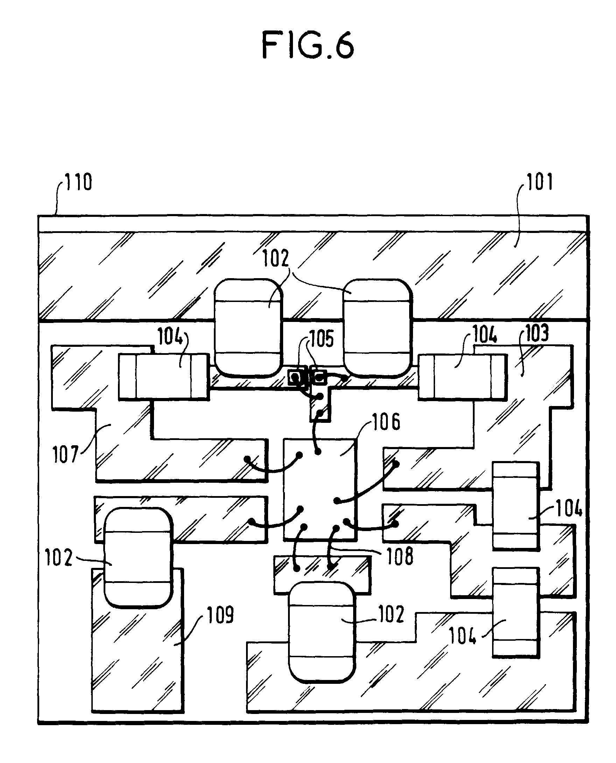

Les indications données ci-dessus à propos d'un premier circuit hybride restent valables à propos d'un deuxième circuit hybride moins simplifié qui va maintenant être décrit avec l'aide de la fig.6. Tout d'abord, de manière générale, ce deuxième circuit comporte :
- deux trous de connexion optiques (non représentés et semblables au trou 32),
- deux photodiodes semi-conductrices 105 constituant deux dits composants optoélectroniques,
- deux fibres optiques (non représentés et semblables à la fibre 28) insérées dans ces deux trous pour réaliser les connexions optiques de ces deux photodiodes, respectivement,
- et au moins un amplificateur à semi-conducteur 106 fonctionnant en hyperfréquence et constituant un dit composant électronique, cet amplificateur étant connecté électriquement à ces deux photodiodes pour constituer avec elles un récepteur optoélectronique équilibré utilisable dans un réseau de transmission à fibres optiques à détection cohérente.

Ces fibres optiques non représentées sont fixées de la même manière que la fibre 28.

Sur la figure 6 les numéros de référence suivants désignent à titre d'exemple les éléments suivants.
- 101 :: Piste formant masse électrique.
- 102 :: Capacité de découplage.
- 103 :: Piste d'alimentation raccordée à une borne positive d'une source de potentiel extérieure non représentée.
- 104 :: Résistances de polarisation.
- 105 :: Deux photodiodes identiques à la photodiode 8 précédemment décrites et fixées de la même manière
- 106 :: Amplificateur à circuit intégré du type dit MMIC.
- 107 :: Piste d'alimentation raccordée à la borne négative de ladite source de potentiel extérieure.
- 108 :: Fils de connexion électriques identiques au fil 26 et soudés de la même manière aux bornes de connexion électrique des divers composants et/ou aux pistes de connexion.
- 109 :: Piste de sortie de signal raccordée à un organe d'utilisation extérieur non représenté.
- 110 :: Substrat identique au substrat 2 précédemment décrit.

## Revendications

1. Procédé de fabrication d'un dispositif optoélectronique du type comprenant un ensemble de composants électroniques (8,16) fixés sur un substrat (2) constitué d'une plaquette céramique, ledit ensemble comportant au moins un composant optoélectronique (8) connecté optiquement à une fibre optique (28) maintenue dans un trou de connection optique (32) traversant ledit substrat, ce procédé comportant les opérations suivantes :
- positionnement d'un ensemble de composants électroniques (8, 16) sur la face supérieure (4) d'un substrat (2) constitué par une plaquette céramique, cet ensemble comportant au moins un composant optoélectronique présentant une plage de connexion optique (10),
- fixation de cet ensemble sur cette face,
- réalisation de connexions électriques (22, 24, 26) pour cet ensemble,
- perçage pour former un trou de connexion optique (32) à travers ledit substrat (2) en regard de ladite plage de connexion optique (10) dudit composant optoélectronique (8), cette opération de perçage étant réalisée à l'aide d'un faisceau laser focalisé selon un axe de perçage (34),
- insertion d'un tronçon extrême (29) d'une fibre optique (28) dans ledit trou de connexion optique,
- et fixation de cette fibre audit substrat pour réaliser une connexion optique de ce composant optoélectronique,
- ce procédé étant caractérisé par le fait qu'on fait tourner ledit substrat (2) autour dudit axe de perçage (34) pendant ladite opération de perçage pour donner sensiblement à la paroi dudit trou de connexion optique (32) la forme d'un cylindre de révolution autour de cet axe et pour donner à ce trou un diamètre adapté à un diamètre extérieur de ladite fibre optique (28).

## Patentansprüche

1. Verfahren zur Herstellung einer optoelektronischen Vorrichtung, die eine Gruppe von elektronischen Bauelementen (8, 16) auf einem von einem Keramikplättchen gebildeten Substrat (2) befestigt aufweist, wobei die Gruppe mindestens ein optoelektronisches Bauteil (8) enthält, das optisch an eine Lichtleitfaser (28) gekoppelt ist, die in einem das Substrat durchquerenden optischen Koppelloch (22) gehalten wird, und wobei das Verfahren die folgenden Schritte enthält:
- Positionierung einer Gruppe von elektronischen Bauelementen (8, 16) an der Oberseite (4) eines von einem Keramikplättchen gebildeten Substrats (2), wobei diese Gruppe mindestens ein optoelektronisches Bauelement enthält, das einen optischen Koppelbereich (10) besitzt,
- Befestigung dieser Gruppe auf dieser Seite,
- Herstellung von elektrischen Anschlüssen (22, 24, 26) für diese Gruppe,
- Bohren eines optischen Koppellochs (32) durch das Substrat (2) gegenüber dem optischen Koppelbereich (10) des optoelektronischen Bauelements (8) mit Hilfe eines auf eine Bohrachse (34) fokussierten Laserstrahls,
- Einführung eines Endabschnitts (29) einer Lichtleitfaser (28) in das optische Koppelloch,
- und Befestigung der Faser am Substrat, um eine optische Kopplung dieses optoelektronischen Bauelements zu bewirken, dadurch gekennzeichnet, daß man das Substrat (2) um die Bohrachse (34) während des Bohrens drehen läßt, um der Wand des optischen Koppellochs (32) die Form eines drehsymmetrischen Zylinders um die Bohrachse zu verleihen und um den Durchmesser des Lochs an den Außendurchmesser der Lichtleitfaser (28) anzupassen.

## Claims

1. Method of manufacturing an optoelectronic device of the type comprising a set of electronic components (8, 16) mounted on a substrate (2) comprising a ceramic plate, said set including at least one opto-electronic component (8) optically connected to an optical fibre (28) held in an optical connection hole (32) through said substrate, the method comprising the following operations:
- placing on a top face (4) of a substrate (2) comprising a ceramic plate a set of electronic components (8, 16) including at least one optoelectronic component having an optical connection region (10),
- fixing said set to said face,
- making electrical connections (23, 24, 26) for said set,
- drilling an optical connection hole (32) along a drilling axis (34) through said substrate (2) facing said optical connection region (10) of said optoelectronic component (8) using a focused laser beam,
- inserting an end section (29) of an optical fibre (28) in said optical connection hole, and
- fixing said fibre to said substrate to make an optical connection to said optoelectronic component,
- this method being characterised in that said substrate (2) is rotated about said drilling axis (34) during said drilling operation so as substantially to confer upon the wall of said optical connection hole (32) the shape of a cylinder of revolution about said axis and so that the diameter of said hole is matched to an outside diameter of said optical fibre (28).
